(19) Europäisches Patentamt
European Patent Office
Office européen des brevets

(11) **EP 1 750 302 B1**

(12) **EUROPÄISCHE PATENTSCHRIFT**

(45) Veröffentlichungstag und Bekanntmachung des Hinweises auf die Patenterteilung:
**21.12.2011 Patentblatt 2011/51**

(51) Int Cl.:
***H01L 23/40*** *(2006.01)*

(21) Anmeldenummer: **06015827.6**

(22) Anmeldetag: **28.07.2006**

(54) **Elektrische Bauelementanordnung**

Arrangement of electrical elements

Arrangement des éléments électriques

(84) Benannte Vertragsstaaten:
**FR IT**

(30) Priorität: **05.08.2005 DE 102005036966**

(43) Veröffentlichungstag der Anmeldung:
**07.02.2007 Patentblatt 2007/06**

(73) Patentinhaber: **Robert Seuffer GmbH & Co. KG**
**75365 Calw-Hirsau (DE)**

(72) Erfinder: **Brand, Matthias**
**87435 Kempten (DE)**

(74) Vertreter: **Eisenführ, Speiser & Partner**
**Postfach 31 02 60**
**80102 München (DE)**

(56) Entgegenhaltungen:
**DE-A1- 10 225 993    DE-A1- 19 538 642**
**DE-A1- 19 543 260    US-A- 5 274 193**
**US-A- 6 081 424**

**Beschreibung**

Die Erfindung betrifft eine elektrische Bauelementanordnung nach dem Oberbegriff des Patentanspruches 1.

Eine derartige elektrische Bauelementanordnung ist aus DE 195 43 260 A1 bekannt. Die bekannte Bauelementanordnung beinhaltet mehrere elektrische Bauelemente, welche als Leistungsbauelemente ausgebildet sind, die mithilfe eines Federkamms gegen eine Fläche einer Wärmeableitungseinrichtung gedrückt sind. Durch den wärmeleitenden Kontakt, den die elektrischen Bauelemente mit der Fläche der Wärmeableitungseinrichtung haben, wird während des Betriebs der elektrischen Bauelemente entstandene Wärme abgeführt. Die als Federkamm ausgebildete Feder wird zwischen zwei einander gegenüberliegenden Gehäuseflächen fixiert. Eine der beiden Flächen bildet dabei die Fläche, an welche das jeweilige elektrische Bauelement mit wärmeleitendem Kontakt gedrückt wird.

Aus US 5 274 193 ist es bekannt, die als Federkamm ausgebildete Feder mit einer Einhängevorrichtung zu versehen und zusätzlich mittels einer Fixierleiste, welche auf die fingerförmigen Federelemente des Federkammes wirkt, im Gehäuse zu fixieren.

Die Druckschrift US 6081424 A offenbart einen U-förmigen Metallclip zur Verbesserung der Wärmeableitung bei elektrischen Komponenten, der an einem Vorsprung zu befestigen ist und zur Montage durch eine Gehäuseöffnung zu führen ist, wobei der Vorsprung ausserhalb des Gehäuses liegt, in dem die zu kühlenden elektrischen Komponenten untergebracht sind.

Die Druckschrift US 5274193 A offenbart zwei Bauteile zum Wärmeableiten durch Ausüben einer Kraft auf Bauelemente über Federelemente, wobei die Federelemente über eine Klemmleiste vorgespannt werden. Die Federelemente sind nebeneinander in Reihe an einem Bauteil vorgesehen, welches an einem Rand eines Wärmeableit-Gehäuses eingehängt wird und teilweise aus dem Gehäuse herausragt.

Aufgabe der Erfindung ist es, eine elektrische Bauelementanordnung der eingangs genannten Art zu schaffen, bei welcher mit verringertem Aufwand die Feder, mit welcher der wärmeleitende Kontakt zwischen dem jeweiligen elektrischen Bauelement und der Wärmeableitungseinrichtung hergestellt wird, fixiert ist.

Diese Aufgabe wird durch die Merkmale des Patentanspruches 1 gelöst.

Bei der Erfindung besitzt die Feder wenigstens zwei Klemmbereiche, die mit einem von der Kraft der Feder beaufschlagten Klemmsitz auf entgegengesetzt liegende Flächen der Befestigungseinrichtung gedrückt sind.

Der Klemmsitz wird vorzugsweise durch Verkanten der beiden Klemmbereiche an den entgegengesetzt liegenden Flächen der Befestigungseinrichtung gebildet.

Die Befestigungseinrichtung kann als wenigstens ein an der Wärmeableitungseinrichtung vorgesehener Vorsprung ausgebildet sein.

Die an der Befestigungseinrichtung, insbesondere am Vorsprung gebildeten entgegengesetzt liegenden Flächen können eben oder gekrümmt ausgebildet sein, wobei die beiden Klemmbereiche, welche Klemmflächen oder Klemmkanten an der Feder sein können, an die Form der Flächen der Befestigungseinrichtung angepasst sind.

Der Klemmsitz wird vorzugsweise durch an den beiden Klemmbereichen im Wesentlichen entgegengesetzt wirkende Kraftkomponenten, die sich aufgrund der Verkantung der Klemmbereiche an der Befestigungseinrichtung ergeben, gebildet.

Zwischen einer Angriffsstelle der Feder am elektrischen Bauelement und den beiden Klemmbereichen kann ein Hebelarm wirksam sein.

Ferner kann die Feder als Federkamm ausgebildet sein, mit welchem mehrere elektrische Bauelemente in wärmeleitendem Kontakt mit der Wärmeableitungseinrichtung gehalten werden.

Die als Federkamm ausgebildete Feder besitzt mehrere Federelemente, welche an ihren einen Enden mittels einer Verbindungsleiste miteinander verbunden sind. Die Klemmbereiche, mit welchen die Feder an der Befestigungseinrichtung fixiert ist, befinden sich vorzugsweise an der Verbindungsleiste.

Bei den elektrischen Bauelementen handelt es sich vorzugsweise um elektrische Leistungsbauelemente, insbesondere Leistungshalbleiter. Diese können mithilfe der Erfindung in einer kompakten Anordnung an der Wärmeübergangsfläche der kühlend wirkenden Wärmeableitungseinrichtung angeordnet werden. Die aus einem oder mehreren Vorsprüngen gebildete Befestigungseinrichtung kann nämlich bei stehender Anordnung der elektrischen Bauelemente oberhalb der elektrischen Bauelemente an der Wärmeableitungseinrichtung vorgesehen sein. Die Wärmeableitungseinrichtung kann vorzugsweise als Fließpressteil oder Druckgussteil, beispielsweise in Wannenform, ausgebildet sein. Da bei der Fixierung der Feder keine zusätzliche Sicherung erforderlich ist, ergibt sich eine einfache Montage bei der Herstellung des Wärmeübergangs zwischen dem jeweiligen elektrischen Bauelement und der kühlend wirkenden Wärmeableitungseinrichtung.

Anhand der Figuren wird die Erfindung noch näher erläutert. Es zeigt:

      Fig. 1 in perspektivischer ausgezogener Darstellung ein Ausführungsbeispiel der Erfindung;
      Fig. 2 das in Fig. 1 dargestellte Ausführungsbeispiel in zusammengebauter Anordnung;
      Fig. 3 die in Fig. 2 dargestellte elektrische Bauelementanordnung in Verbindung mit weiteren auf einer gedruckten Leiterplatte vorgesehenen Bauelementen; und

Fig. 4 in schnittbildlicher Seitenansicht ein Ausführungsbeispiel der Befestigungseinrichtung zur Fixierung der Feder mit zwischen der Feder und der Wärmeableitungseinrichtung angeordnetem elektrischen Bauelement.

Das in den Figuren dargestellte Ausführungsbeispiel einer elektrischen Bauelementanordnung beinhaltet eine Wärmeableitungseinrichtung 4, welche wannenförmig ausgebildet ist. Die Wärmeableitungseinrichtung kann als Fließpressteil oder Druckgussteil, insbesondere aus Metall, ausgebildet sein. Ein elektrisches Bauelement oder wie beim Ausführungsbeispiel dargestellt, mehrere elektrische Bauelemente, insbesondere Leistungsbauelemente 1, werden mithilfe einer Feder 2 mit wärmeleitendem Kontakt gegen eine ebene Fläche 3 an der Wärmeableitungseinrichtung 4 gedrückt. Zwischen den elektrischen Bauelementen 1 und der Fläche 3 befindet sich eine Isolierfolie 13.

Die Feder 2 ist als Federkamm ausgebildet und besitzt mehrere fingerförmige Federelemente 12, die an ihren einen Enden über eine Verbindungsleiste 11 miteinander verbunden sind.

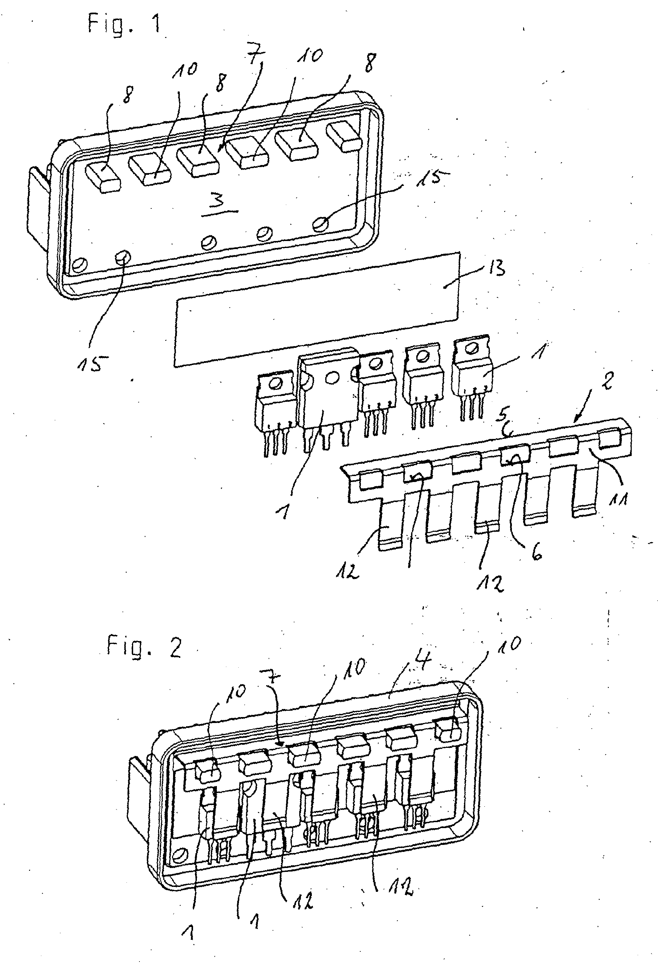

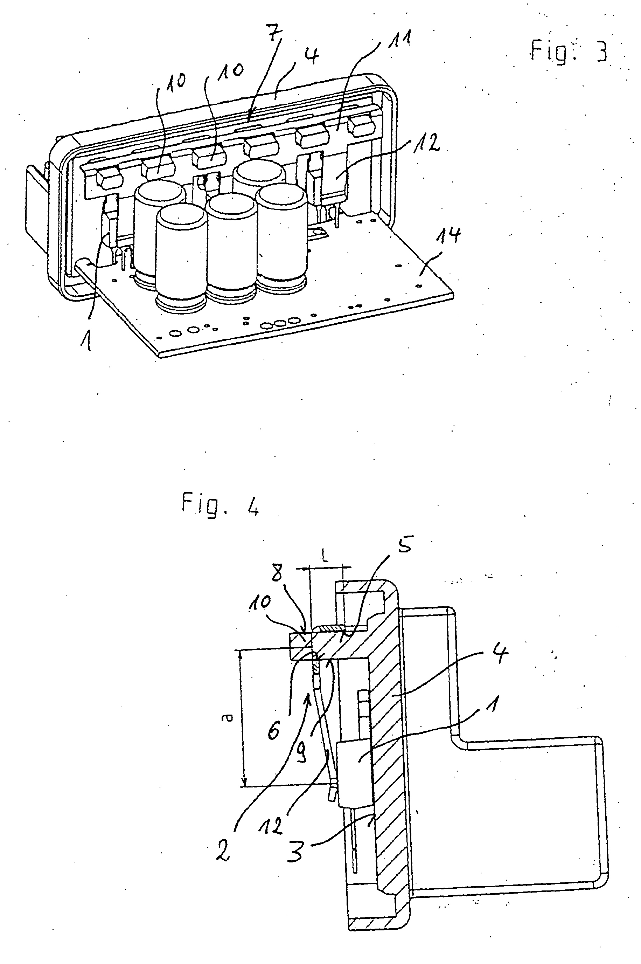

Im Bereich der Verbindungsleiste 11 ist die kammförmige Feder 2 an einer Befestigungseinrichtung 7 an der Wärmeableitungseinrichtung 4 befestigt. Die Befestigungseinrichtung 7 besteht aus mehreren Vorsprüngen 10, die im oberen Bereich aus der Fläche 3 ragen. Die Fixierung der Feder 2 erfolgt durch Klemmsitz, welcher im Bereich der Verbindungsleiste 11 an den Vorsprüngen 10 der Befestigungseinrichtung 7 jeweils hergestellt wird. Wie aus der Figur 4 zu ersehen ist, sind an der Feder 2 im Bereich der Verbindungsleiste 11 Klemmbereiche 5 und 6 vorgesehen. Beim dargestellten Ausführungsbeispiel sind jedem Vorsprung 10 der Befestigungseinrichtung 7 jeweils zwei Klemmbereiche 5 und 6 an der Feder 2 im Bereich der Verbindungsleiste 11 zugeordnet. Die Klemmbereiche 5 und 6 liegen an entgegengesetzt liegenden Flächen 8 und 9 eines jeweiligen Vorsprungs 10 der Befestigungseinrichtung 7 an. Der Klemmbereich 5 liegt an einer oben liegenden Fläche 8, und der Klemmbereich 6 liegt an einer unten liegenden Fläche 9 eines jeweiligen Vorsprungs 10 der Befestigungseinrichtung 7 an. Der unten liegende Klemmbereich 6 ist an der Feder als Klemmkante ausgebildet. Der oben liegende Klemmbereich 5 ist an der Feder flächig ausgebildet und wird von Kanten, insbesondere einer durchgehenden innen liegenden Kante, wie aus der Fig. 1 zu ersehen ist, begrenzt.

Beim Aufdrücken der Feder 2 auf die nebeneinander angeordneten Bauelemente 1 erfolgt ein Verkanten der beiden Klemmbereiche 5 und 6, insbesondere zwischen der durchgehenden innen liegenden Begrenzungskante des oben liegenden flächigen Klemmbereiches 5 und der unten liegenden Klemmkante 6. Diese Verkantung mit einer Führungslänge L (Fig. 4) wird durch die Federkraft der Feder 2 aufrechterhalten. Die Führungslänge L entspricht dem Abstand der Klemmsitzstellen, welche die Verkantung bewirken, parallel zur Mittelebene zwischen den beiden Klemmsitzstellen. Aufgrund dieser Verkantung ergibt sich ein jeweiliger Klemmsitz, mit welchem die Feder 2 an den Vorsprüngen der Befestigungseinrichtung 7 fixiert ist. Dieser Klemmsitz bildet auch das Widerlager, mit welcher die Federelemente 12 auf die jeweiligen Bauelemente 1 drücken, so dass der wärmeleitende Kontakt zur Fläche 3 an der Wärmeableitungseinrichtung 4 hergestellt wird.

Zwischen den jeweiligen Krafteinleitungspunkten, mit welchen die Feder 2 jeweils am Bauelement 1 anliegt, und einer Mittelebene zwischen den beiden Klemmbereichen 5 und 6 befindet sich ein senkrechter Abstand (Hebelarm) a. Für einen ausreichenden selbsttätigen Klemmsitz gilt die Beziehung

$$L > 2a\mu,$$

wobei $\mu$ der Reibungskoeffizient zwischen den Klemmbereichen und dem jeweiligen Vorsprung 10 der Befestigungseinrichtung 7 ist.

Bei stehender Anordnung der elektrischen Bauelemente 1 befinden sich die Vorsprünge 10 der Befestigungseinrichtung 7 oberhalb der nebeneinander angeordneten Bauelemente 1.. Im unteren Bereich der Fläche 3 können Ausnehmungen 15 vorgesehen sein, in die entsprechende Vorsprünge einer gedruckten Leiterplatte 14 eingesteckt sind, wie es aus Fig. 3 zu ersehen ist. Die elektrischen Bauelemente 1 sowie zusätzliche Bauelemente können an der gedruckten Leiterplatte 14 kontaktiert sein. Bei der Fixierung der Feder 2 zur Herstellung eines Anpressdruckes von beispielsweise > 1 kp an jedem Bauelement 1 werden die Kontaktstellen, insbesondere Lötstellen, mit denen die elektrischen Bauelemente 1 an der gedruckten Leiterplatte 14 kontaktiert sind, mechanisch nicht belastet. Die bei der Fixierung der Feder 2 zur Wirkung kommenden Kräfte werden im Klemmsitz der Feder an den jeweiligen Vorsprüngen 10 der Befestigungseinrichtung 7 aufgenommen.

**Bezugszeichenliste**

| | |
|---|---|
| 1 | Bauelement |
| 2 | Feder |
| 3 | Wärmeableitende Fläche |
| 4 | Wärmeableitungseinrichtung |
| 5, 6 | Klemmbereiche |
| 7 | Befestigungseinrichtung |
| 8, 9 | Entgegengesetzt liegende Flächen an der Befestigungseinrichtung |
| 10 | Vorsprünge |
| 11 | Verbindungsleiste |
| 12 | Federelemente |

13   Isolierfolie
14   Gedruckte Leiterplatte
15   Ausnehmungen in der Wärmeableitungseinrichtung

**Patentansprüche**

1. Elektrische Bauelementanordnung von mehreren elektrischen Bauelementen an einer Wärmeableitungseinrichtung mittels einer als Federkamm ausgebildeten Feder (2), welche eine Verbindungsleiste (11) aufweist, mit welcher Federelemente (12) an ihren Enden miteinander verbunden sind, wobei die Feder (2) im Bereich der Verbindungsleiste (11) an mehreren Befestigungsstellen an der Wärmeableitungseinrichtung befestigt ist und die elektrischen Bauelemente durch die Federelemente gegen eine Fläche der Wärmeableitungseinrichtung gedrückt werden, **dadurch gekennzeichnet, dass** an den mehreren Befestigungsstellen jeweils ein Vorsprung (10) an der Seite der Wärmeableitungseinrichtung (4), gegen welche die elektrischen Bauelemente (1) gedrückt sind, vorgesehen ist, und dass mit einer bestimmten Führungslänge (L) verkantete Klemmkanten (5, 6), welche mit einem von der Kraft der Feder (2) beaufschlagten Klemmsitz in Klemmsitzstellen (5,6) an entgegengesetzt liegende Flächen (8, 9) des jeweiligen Vorsprungs (10) gedrückt sind, an der Verbindungsleiste (11) vorgesehen sind, wobei die Führungslänge gemäß der Beziehung $L > 2\,a\mu$ bemessen ist, in welcher $a$ einen Hebelarm zwischen einer Mittelebene zwischen den beiden Klemmsitzstellen (5,6) und einer Angriffsstelle, an welcher ein jeweiliges Federelement (12) am Bauelement (1) angreift, und $\mu$ den Reibungskoeffizienten zwischen den Klemmkanten (5, 6) und dem jeweiligen Vorsprung (10) bedeuten.

2. Elektrische Bauelementanordnung nach Anspruch 1, **dadurch gekennzeichnet, dass** die Federelemente (12) an nebeneinander angeordneten elektrischen Bauelementen (1) anliegen.

3. Elektrische Bauelementanordnung nach Anspruch 1 oder 2, **dadurch gekennzeichnet, dass** die elektrischen Bauelemente (1) in stehender Anordnung nebeneinander angeordnet sind und die Befestigungseinrichtung (7) zur Fixierung der Feder (2) mittels des Klemmsitzes oberhalb der elektrischen Bauelemente (1) angeordnet ist.

**Claims**

1. Electric component assembly of a plurality of electric components on a heat dissipation device by means of a spring (2) formed as a spring comb and having a connection rail (11) connecting spring elements (12) at their ends to each other, wherein the spring (2) in the region of the connecting rail (11) is fixed to the heat dissipation device at a plurality of fixing points, and the electric components are pressed to a surface of the heat dissipating device by the spring elements, **characterized in that** a protrusion (10) is provided at each of said plurality of fixing points on that side of the heat dissipation device (4) to which the electric components (1) are pressed, and that clamping edges (5, 6) wedged with a defined guiding length (L) are provided on the connecting rail (11), the clamping edges (5, 6) being pressed by the force of the spring (2) with clamping fit into clamping seat positions (5, 6) on opposite surfaces (8, 9) of the respective protrusion (10), wherein the guiding length is dimensioned according to the interrelation $L < 2\,a\mu$, wherein $\underline{a}$ is a lever arm between a center plane between the two clamping seat positions (5, 6) and a position of attack at which a respective spring element (12) attacks a component (1), and $\mu$ is the friction coefficient between the clamping edges (5, 6) and the respective protrusion (10).

2. Electric component assembly according to claim 1, **characterized in that** the spring elements (12) rest against electric components (1) adjacent to each other.

3. Electric component assembly according to claim 1 or 2, **characterized in that** the electric components (1) are arranged adjacent to each other in upright arrangement, and the fixing device (7) is arranged above the electric components (1) by the clamping fit for fixing the spring (2).

**Revendications**

1. Ensemble d'éléments électriques, comprenant plusieurs éléments électriques fixés sur un dispositif dissipateur de chaleur au moyen d'un ressort (2) réalisé en forme de peigne à ressort qui présente une barrette de liaison (11) au moyen de laquelle des éléments de ressort (12) sont reliés les uns aux autres à leurs extrémités, le ressort (2) étant fixé dans la zone de la barrette de liaison (11) à plusieurs emplacements de fixation au dispositif dissipateur de chaleur et les éléments électriques étant comprimés par les éléments de ressort contre une surface du dispositif dissipateur de chaleur, **caractérisé en ce qu'**il est prévu à chacun desdits emplacements de fixation une saillie (10) sur la face du dispositif dissipateur de chaleur (4) contre laquelle les éléments électriques (1) sont comprimés, et **en ce qu'**il est prévu sur la barrette de liaison (11) des bords de serrage repliés (5, 6), avec une longueur de guidage (L) déterminée, qui sont comprimés par une portée de serrage précontrainte par la force du ressort (2) à des emplacements de portées de serrage (5, 6) contre des surfaces opposées (8, 9) de la saillie (10) correspondante, la longueur de guidage étant donnée par la relation L > 2 aµ, où a représente un bras de levier entre un plan médian entre les deux emplacements de portées de serrage (5, 6) et un emplacement d'attaque auquel un élément de ressort (12) correspondant est en prise avec l'élément (1) et µ représente le coefficient de frottement entre les bords de serrage (5, 6) et la saillie (10) correspondante.

2. Ensemble d'éléments électriques selon la revendication 1, **caractérisé en ce que** les éléments de ressort (12) sont en appui sur des éléments électriques (1) disposés les uns à côté des autres.

3. Ensemble d'éléments électriques selon la revendication 1 ou la revendication 2, **caractérisé en ce que** les éléments électriques (1) sont disposés les uns à côté des autres selon une disposition verticale, et **en ce que** le dispositif de fixation (7) servant à fixer le ressort (2) au moyen de la portée de serrage est disposé au-dessus des éléments électriques (1).

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19543260 A1
- US 5274193 A
- US 6081424 A